Europäisches Patentamt

European Patent Office

Office européen des brevets

(19)

(11) Publication number:

# 0 265 584
A2

(12)

# EUROPEAN PATENT APPLICATION

(21) Application number: 87106471.3

(22) Date of filing: 05.05.87

(51) Int. Cl.⁴: **H 01 L 21/31**

(30) Priority: 30.10.86 US 924711

(43) Date of publication of application: 04.05.88
Bulletin 88/18

(84) Designated Contracting States: DE FR GB

(71) Applicant: **International Business Machines Corporation, Old Orchard Road, Armonk, N.Y. 10504 (US)**

(72) Inventor: **Bennett, Reid Stuart, 6 Pye Lane, Wappingers Falls, N.Y. 12590 (US)**
Inventor: **Chao, Hu Herbert, 4 Stella Lane, Pleasantville, N.Y. 10570 (US)**
Inventor: **Sackies, Paul Edward, 1153 Glenn Avenue, San Jose California 95125 (US)**

(74) Representative: **Teufel, Fritz, Dipl.-Phys. et al, IBM Deutschland GmbH. Europäische Patentdienste Postfach 265, D-8000 München 22 (DE)**

(54) Method and materials for etching silicon dioxide using silicon nitride or silicon rich dioxide as an etch barrier.

(57) A process for etching SiO₂ using either silicon rich SiO₂ or Si₃N₄ as an etching barrier over a substrate. Selectivity is obtained between the two dielectric materials, silicon dioxide and silicon nitride or silicon dioxide and silicon rich silicon dioxide wherein the oxide etches considerably faster than nitride (or silicon rich silicon dioxide) because of the selectivity of oxide to nitride. A further object of the present invention is to provide an etching process wherein the silicon dioxide on the substrate is directionally etched in a fluorocarbon gas to form silicon dioxide spacers on a substrate, and the substrate surface ist protected by an etch stop composed of the silicon nitride or silicon rich silicon dioxide material.

EP 0 265 584 A2

1

# METHOD AND MATERIALS FOR ETCHING SILICON DIOXIDE USING SILICON NITRIDE OR SILICON RICH DIOXIDE AS AN ETCH BARRIER

## BACKGROUND OF THE INVENTION

### Field of the Invention

The present invention relates to etching processes and materials and more particularly to an etching process and and etch stop structure for directionally etching silicon dioxide with high selectivity to an etch stop consisting of silicon nitride or silicon rich silicon dioxide.

### Description of the Prior Art

In U.S. Patent 4,324,611 issued April 13, 1982 to Vogel et al, entitled PROCESS AND GAS MIXTURE FOR ETCHING SILICON DIOXIDE AND SILICON NITRIDE, a process and gas mixture for etching silicon dioxide and/or silicon nitride in a plasma environment in a planar reactor is described. The gas mixture comprises a primary etching gas and a secondary gas which controls the selectivity of the etch. The process is carried out at relatively high pressure and power levels and provides substantially fast removal of silicon dioxide and/or silicon nitride.

U.S. Patent 4,427,516 issued January 24, 1984 to Levinstein et al, entitled APPARATUS AND METHOD FOR PLASMA-ASSISTED ETCHING OF WAFERS teaches a plasma-assisted etching apparatus and method

YO 986 007

2

designed to pattern silicon dioxide in a plasma derived from a mixture of trifluoromethane and ammonia wherein surfaces in the reaction chamber are coated with a layer of silicon. Contamination of wafers during the etching process is thereby substantially reduced.

U.S. Patent 4,376,672 issued March 15, 1983 to Wang et al describes a method for etching a layer of inorganic insulating material formed on a semiconductor wafer and containing silicon as the principal metallic element. The method involves disposing a wafer on one of a pair of electrode structures in a closed chamber. A reactive gas mixture comprising principally a fluorocarbon gas doped with a preselected quantity of carbon dioxide is supplied to the chamber.

Radio frequency electrical energy is suppled to one of the electrode structures to create a plasma of the reactive gas mixture for chemically attacking the insulating material.

U.S. Patent 4,431,477 issued February 14, 1984 to Zajao entitled PLASMA ETCHING WITH NITROUS OXIDE AND FLUORO COMPOUND GAS MIXTURE discloses a process for use in the manufacture of multilayer thin film integrated circuits for selective removal of specific layers, and a composition of matter useful in the process for selective etching of polysilicon and silicon nitrides during the manufacture of thin film integrated circuits. A multilayer thin film integrated circuit is exposed to a plasma formed

YO 986 007

3

from a gaseous mixture of nitrous oxide and a fluoro compound. The nitrous oxide preferably comprises between 2.5% and 9.0% of the mixture and the fluoro compound preferably comprises between 91.0% and 97.5% of the mixture.

In U.S. Patent 4,283,249 entitled REACTIVE ION ETCHING issued August 11, 1981 to Ephrath, a process is described wherein a silicon oxide, nitride and/or oxynitride surface on a substrate is selectively etched at a rate greater than that of the substrate by a reactive ion etching employing a gaseous mixture containing a fluorocarbon and a second gas capable of supplying hydrogen.

U.S. Patent 4,490,209 issued December 25, 1984 to Hartman entitled PLASMA ETCHING USING HYDROGEN BROMIDE ADDITION relates to a plasma etch chemistry which allows a near perfectly anisotropic etch of silicon. A Cl-containing compound such as HCl has HBr added thereto, readily allowing the anisotropic etching of silicon. This is due to the low volatility of $SiBr_4$. The silicon surface facing the discharge is subjected to ion bombardment, allowing the volatization (etching) of silicon as a Si-Cl-Br compound. The Br which absorbs on the sidewalls of the etched silicon passivates them from the etching.

The present invention is distinct from the described prior art. In particular, U.S. Patent 4,431,477 discusses the use of Freon 13 with nitrous oxide to etch nitride at a faster rate than

YO 986 007

4

oxide. This is in contrast to the present invention wherein nitride is caused to etch significantly slower than oxide.

U.S. Patent 4,376,672 and 4,283,249 discuss selective etching of oxide and nitride to silicon. In both cases, only silicon can be used as an etching barrier. U.S. Patent 4,490,209 claims selective etching of silicon to nitride. Although nitride is used as an etching barrier, the applications of patterning silicon are generally quite different from that of defining an oxide layer. The features of the present invention are unique in that selectivity is obtained between two dielectric materials, silicon dioxide and nitride wherein oxide etches considerably faster than nitride in this process.

## SUMMARY OF THE INVENTION

It is known that $CClF_3 + H_2$ will etch $SiO_2$ directionally with high selectivity to $Si_3N_4$ and silicon rich $SiO_2$. It has also been shown in the prior art that the use of a dielectric material as an etch stop prevents the transfer of topography into underlaying layers of wafer material such as an $SiO_2$ film used as isolation.

An object of the present invention is to provide a process for etching $SiO_2$ using either silicon rich $SiO_2$ or $Si_3N_4$ as an etching barrier over a substrate.

YO 986 007

5

Another object of the present invention is to provide an etching process wherein selectivity is obtained between two dielectric materials, silicon dioxide and nitride or silicon dioxide and silicon rich silicon dioxide wherein the oxide etches considerably faster than nitride or silicon rich silicon dioxide because of the selectivity of oxide to nitride.

A further object of the present invention is to provide an etching process wherein silicon dioxide on a substrate is directionally etched in a fluorocarbon gas to form silicon dioxide spacers on a substrate, and wherein the substrate surface is protected by an etch stop composed of silicon nitride or silicon rich silicon dioxide.

The foregoing and other objects features and advantages of the invention will be apparent from the following more particular description of the invention as illustrated in the accompanying drawings.

DESCRIPTION OF THE INVENTION

FIG. 1 is a schematic illustration of a typical reactive ion etching system used to carry out the etching process of the present invention.

FIG. 2 is a schematic illustration of an embodiment of a semiconductor structure with a shallow junction therein showing a layer of silicon dioxide

YO 986 007

6

thereon which is to be etched to form a sidewall spacer.

FIG. 3 is a schematic illustration of the structure of FIG. 2 at the completion of the etch process showing how the prior art etch process may remove a portion of a doped shallow junction.

FIG. 4 is a schematic illustration of another embodiment of a structure with a semi-recessed oxide showing a layer of silicon dioxide thereon which is to be etched to form a sidewall spacer.

FIG. 5 is a schematic illustration of the embodiment of FIG. 4 at the completion of the etch process showing how the prior art etch process may remove a portion of the semi-recessed oxide.

FIG. 6 is an illustration showing the etch rates of silicon dioxide, silicon nitride and silicon within $CClF_3+H_2$ etch gas of different hydrogen percentages.

FIG. 7 is a schematic illustration of a semiconductor structure with a shallow junction therein showing a layer of silicon dioxide over an etch barrier according to the principles of the present invention.

FIG. 8 is a schematic illustration of the structure of FIG. 7 at the completion of the etching of the silicon dioxide to form a sidewall spacer with the

YO 986 007

7

substrate protected by an etch barrier according to the principles of the present invention.

FIGS. 9 and 10 are schematic illustrations of the structure of FIG. 7 showing the removal of the etch barrier.

FIGS. 11, 12 and 13 are schematic illustrations of an embodiment of a semiconductor structure with a semi-recessed oxide isolation region therein showing steps of an etch process employing an etch barrier according to the principles of the present invention.

DESCRIPTION OF THE INVENTION

The process of the present invention includes etching, for example, reactive ion etching. Although the means for carrying out the reactive ion etching is available in the art, and does not form a separate portion of the present invention, a typical reactive ion etching structure will be described to provide a complete disclosure.

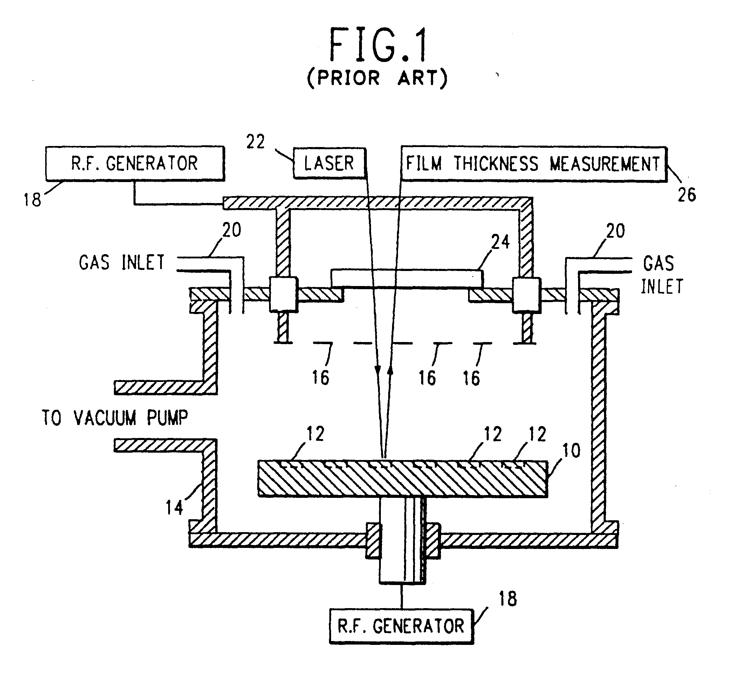

A typical reactive ion etching system is shown in FIG. 1 including a support means 10 for mounting recessed work specimens within an enclosed vacuum chamber 14. The work specimens are disposed between a pair of electrodes 12,16 which are energized with radio frequency power from R.F. generator 18 to produce an electric field for ionizing a gas which is introduced through inlets 20. Control of the etching process is

YO 986 007

8

maintained by directing a laser beam from laser 22 through window 24 and which is reflected from the specimen surface to a thickness measurement means 26.

In the present invention, the etching of the silicon dioxide material is carried out by an etch gas consisting of $CClF_3 + H_2$, and more particularly thirty percent 20 millitorr $CClF_3$ plus seventy percent $H_2$ with a power density of 0.35 watts/cm² in a 7, 82 mm wafer reactive ion etch system.

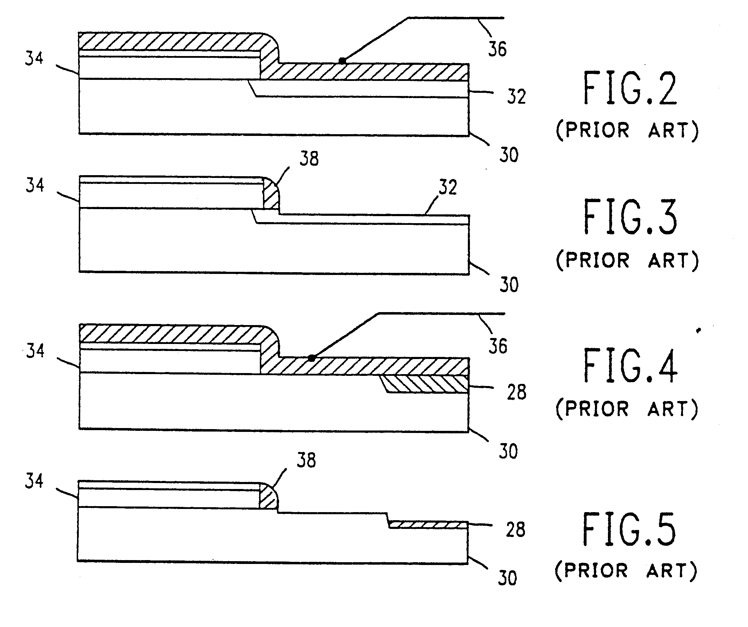

Referring now to FIG. 2, an illustration is provided showing a prior art example of an etch process for forming a silicon dioxide spacer sidewall. A substrate 30, such as silicon or gallium arsenide contains a shallow doped junction region 32 and a polysilicon layer 34. A layer of silicon dioxide 36 is formed on the polysilicon 34 and junction 32, for example, by chemical vapor deposition. The structure is reactive ion etched in a system as shown in FIG. 1. The etching is directional normal to the structure surface such that a silicon dioxide sidewall 38 remains, as shown in FIG. 3.

It has been observed, that even with silicon selectivity etch, a portion of the surface of the doped junctions is etched away before the etch process can be halted. However, even if as little as 100 Angstroms of the doped shallow junction is removed, it will have detrimental effects on the resultant structure.

00265584

9

Referring to FIG. 4, another embodiment of a structure is shown including a semi-recessed oxide region 28 rather than a shallow junction. The remainder of the structure of FIG. 4 is the same as shown in FIG. 2.

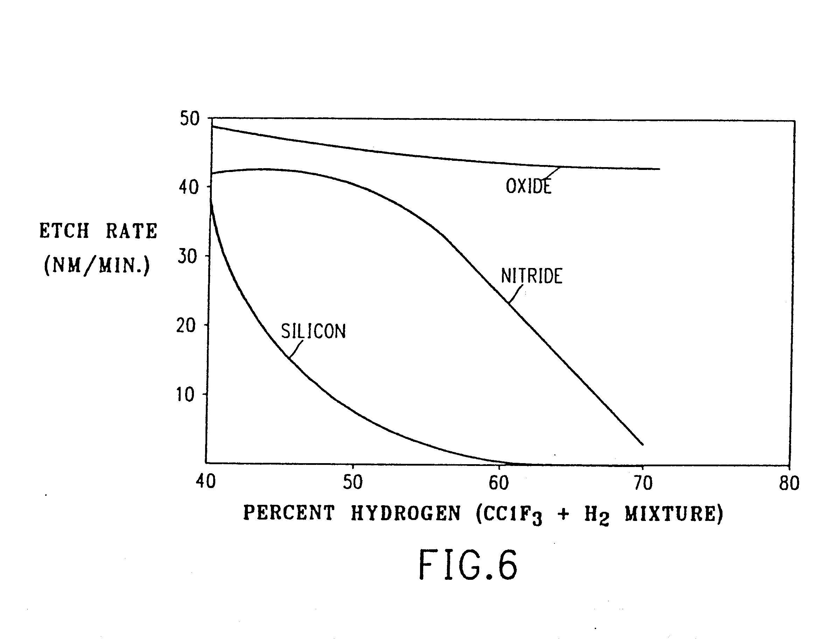

The structure of FIG. 4 is directionally reactively ion etched in the system of FIG. 1 to remove the silicon dioxide layer 36 and provide sidewall spacer 38 as shown in FIG. 5. However, a significant portion of the semi-recessed oxide region 28 is also removed during the etching process, to the detriment of the resultant device structure.

Referring next to FIG. 6, an illustration of curves showing the etch rates of silicon dioxide, silicon nitride and silicon in $CClF_3 + H_2$ is depicted. At a pressure of 25 millitorr and a gas flow rate of 135 sccm the etch rate of silicon dioxide is shown to be higher than silicon nitride and silicon, with the differences between the etch rates becoming larger as the percentage of $H_2$ in the gas mixture increases to seventy percent ($\pm 7$ percent). The application of this etch rate difference is used in the etch barrier structure of the process of the present invention.

The fact that the silicon nitride and the silicon rich silicon dioxide (that is, having a very high silicon content, for example, forty percent silicon in the silicon dioxide compound) etch more slowly than normal silicon dioxide may be a result of the $CClF_3 + H_2$ etching gas being highly selective to silicon, in the order of 70 to 80 to 1. Thus, the

YO 986 007

10

silicon nitride, which is composed of about 43% Si as opposed to silicon dioxide which is composed of about 33% Si, etches more slowly than the silicon dioxide. The same is true of silicon rich $SiO_2$ which has a much higher silicon content than regular $SiO_2$.

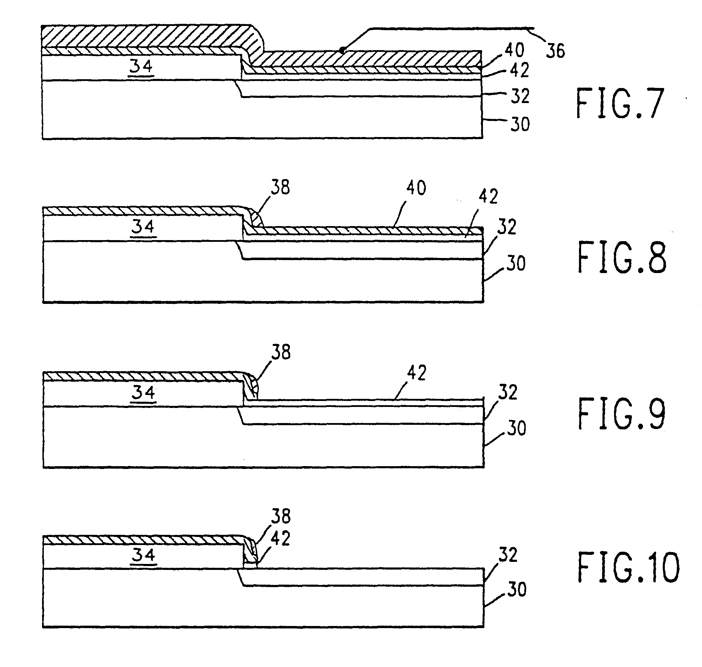

Referring to FIGS. 7, 8 and 9, the process of the present invention is shown for fabricating a silicon dioxide sidewall spacer and a structure containing a shallow doped junction similar to the structure of FIGS. 2 and 3.

In FIG 7, the substrate 30 contains a shallow doped junction 32 and a polysilicon layer 34. An etch barrier 40 is deposited on the surface of the structure. If the substrate 30 is single crystal silicon, and if the etch barrier 40 is composed of silicon nitride, normal practice requires a thin passivating layer 42 of silicon dioxide to be placed between the nitride and the silicon to prevent defect formation. If the etch barrier is silicon rich silicon dioxide, such passivating layer 42 is not needed. Likewise, the passivating layer 42 may be unnecessary if the substrate 30 is composed of gallium arsenide.

A layer of silicon dioxide 36 insulating material is then deposited on the surface of the structure as described for FIG. 2.

The structure is then directionally etched in the system of FIG. 1 to provide the sidewall spacer 38

YO 986 007

in FIG. 8. However, because the silicon nitride etches slower than the silicon dioxide, when the sidewall is completed, there is still a thickness of silicon nitride etch barrier protecting the surface of the shallow junction.

In FIG. 9, the structure is reactively ion etched using $CF_4$ as the etching gas to remove the nitride layer 40. If a passivating layer 42 is used, it is removed by using a wet etching with a buffered HF solution which has infinite selectivity to silicon and, therefore, no junction material is removed as shown in FIG. 10.

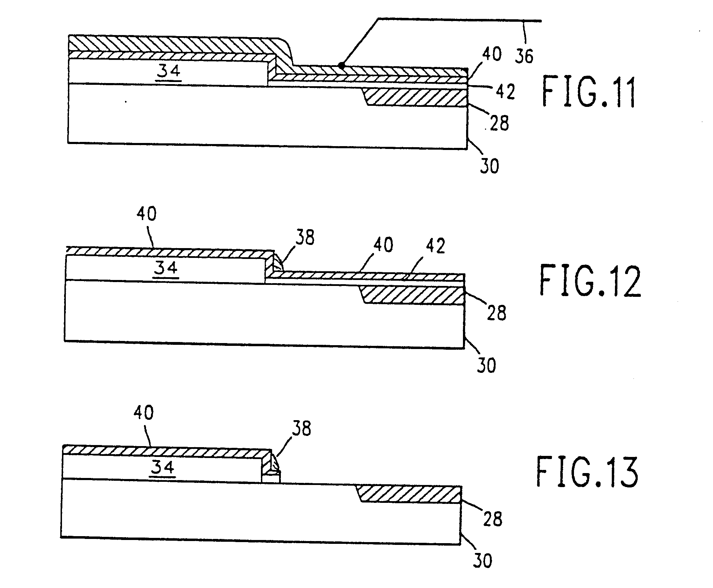

FIGS. 11, 12 and 13 illustrate the use of a barrier layer according to the present invention in a process for forming a sidewall on a structure including semi-recessed oxide.

In FIG. 11, a substrate 30 is provided having a semi-recessed oxide region 28 therein, and a layer of polysilicon 34 similar to the structure of FIG. 4.

As described for FIG. 7, a silicon nitride etch barrier layer is formed and, if necessary, a thin silicon dioxide passivating layer 42 is first deposited on the structure surface.

FIG. 12 illustrates the first process step, which is the same as described for FIG. 8, wherein a directional reactive ion etch is performed to

12

remove the silicon dioxide layer 36 with the exception of the remaining sidewall 38.

In FIG. 13, the nitride layer 40 is removed by reactive ion etching in $CF_4$ similar to the step of FIG. 9 and, if present, the passivating silicon dioxide layer 42 is also removed by reactive ion etching in $CF_4$.

13

CLAIMS

1.  A process for etching a layer of silicon dioxide disposed on a semiconductor substrate employing a layer of silicon rich material as an etch barrier comprising the steps of:

    1) over a semiconductor substrate having regions of material on the surface thereof including vertical sidewall surfaces, normal to said substrate surface, disposing a first layer of material having a silicon content substantially greater than the amount of silicon content in silicon dioxide;

    2) disposing a layer of silicon dioxide over said first layer;

    3) directionally etching said silicon dioxide layer in a direction normal to said substrate surface to remove said silicon dioxide except for regions disposed on said vertical sidewall surfaces, wherein said first layer disposed under said silicon dioxide layer is etched at a slower rate relative to said silicon dioxide to function as an etch barrier over said semiconductor substrate surface.

2.  A process according to Claim 1 wherein said first layer is composed of silicon nitride.

YO 986 007

14

3.  A process according to Claim 1 wherein said
    first layer is composed of silicon dioxide
    having an amount of silicon content substantially greater than the amount of silicon in
    said silicon dioxide layer of step 2.

4.  A process according to Claim 1 wherein said
    silicon dioxide layer is directionally etched
    by reactive ion etching in a $CClF_3$ + $H_2$ gas
    environment.

5.  A process according to Claim 1 wherein said
    semiconductor substrate is composed of silicon.

6.  A process according to Claim 1 wherein said
    semiconductor substrate is composed of gallium
    arsenide.

7.  A process according to Claim 2 wherein said
    semiconductor substrate is composed of silicon
    and wherein the disposition of said silicon
    nitride layer is preceded by the deposition of
    a passivating layer of silicon dioxide.

8.  A process according to Claim 1 wherein, after
    step 3, said first etch barrier layer is
    removed by etching.

YO 986 007

00265584

1/5

# FIG.1
## (PRIOR ART)

FIG.2
(PRIOR ART)

FIG.3
(PRIOR ART)

FIG.4
(PRIOR ART)

FIG.5
(PRIOR ART)

FIG.6

FIG.7

34
40
36
42
32
30

FIG.8

38
40
42
34
32
30

FIG.9

38
42
34
32
30

FIG.10

38
42
34
32
30

FIG.11

FIG.12

FIG.13

IBM — YO 986 007